(19) Europäisches Patentamt
European Patent Office
Office européen des brevets

(11) **EP 1 035 416 A2**

(12) **EUROPÄISCHE PATENTANMELDUNG**

(43) Veröffentlichungstag:
**13.09.2000 Patentblatt 2000/37**

(51) Int. Cl.⁷: **G01R 33/48**, **G01R 33/62**

(21) Anmeldenummer: **00200801.9**

(22) Anmeldetag: **03.03.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **12.03.1999 DE 19911043**

(71) Anmelder:
• **Philips Corporate Intellectual Property GmbH**
**52064 Aachen (DE)**
Benannte Vertragsstaaten:
**DE**

• **Koninklijke Philips Electronics N.V.**
**5621 BA Eindhoven (NL)**
Benannte Vertragsstaaten:
**FR GB NL**

(72) Erfinder:
• **Overweg, Johannes Adrianus**
**52064 Aachen (DE)**
• **Leussler, Christoph Günter**
**52064 Aachen (DE)**

(74) Vertreter: **Gössmann, Klemens**
**Philips Corporate Intellectual Property GmbH,**
**Habsburgerallee 11**
**52064 Aachen (DE)**

(54) **MR-Verfahren**

(57) Die Erfindung betrifft ein MR-Verfahren, bei dem die Kernmagnetisierung unter dem Einfluss eines ersten stationären Magnetfeldes erhöht wird und bei dem ein zweites stationäres Magnetfeld auf die zuvor auf das erste Magnetfeld beeinflussten Kerne einwirkt. Erfindungsgemäß überlappen sich die beiden Magnetfelder zeitlich und schließen miteinander einen von 0° verschiedenen Winkel ein, vorzugsweise 90°. Die erhöhte Kernmagnetisierung bleibt dabei nach dem Abschalten des ersten stationären Magnetfeldes noch erhalten, während die Richtung der Kernmagnetisierung durch das zweite stationäre Magnetfeld bestimmt wird. Die Verwendung zweier zueinander senkrechter Magnetfelder ist insbesondere für Overhauser-Abbildungsverfahren von Vorteil, weil sie die Verwendung von zueinander senkrechten Hochfrequenzfeldern für die ESR-Sättigung und die MR-Anregung erlaubt, wodurch die Spulen, die diese Hochfrequenzfelder erzeugen voneinander entkoppelt werden.

FIG. 2

**Beschreibung**

Die Erfindung betrifft ein MR-Verfahren mit den Schritten

- Erzeugung einer erhöhten Kernmagnetisierung in einem Untersuchungsbereich unter dem Einfluss eines ersten stationären Magnetfeldes,
- Einwirken eines zweiten stationären Magnetfeldes auf die zuvor durch das erste Magnetfeld beeinflussten Kerne und
- Durchführung mindestens eines MR-Experiments, nachdem das erste stationäre Magnetfeld nicht mehr auf die Kerne einwirkt, jedoch bevor die durch dieses Magnetfeld beeinflusste Kernmagnetisierung abgeklungen ist, wobei das MR-Experiment die Anregung der Kernmagnetisierung durch ein MR-Hochfrequenzmagnetfeld unter dem Einfluss des zweiten stationären Magnetfeldes umfasst.

Außerdem bezieht sich die Erfindung auf eine Anordnung zur Durchführung eines solchen Verfahrens.

Ein Verfahren der eingangs genannten Art ist bereits aus einem Aufsatz von Baras et al.in Proceedings SMR/ESRMB, Nice, 1995, Vol 2,p. 692 bekannt. Bei diesem Verfahren wird zunächst eine erhöhte Kernmagnetisierung (bzw. magnetische Polarisation) mit Hilfe des ersten stationären Magnetfeldes erzeugt. Dieses Magnetfeld wird nur kurzzeitig eingeschaltet (der Begriff "stationär" ist daher im Zusammenhang mit der Erfindung weit auszulegen; auch ein Magnetfeld, das nur für einige Zehntel Sekunden einen stationären Wert hat, gilt in diesem Sinne als "stationär"). Das erste stationäre Magnetfeld muss sehr stark sein, aber die Anforderungen an seine Homogenität sind gering. Anschließend wirkt ein zweites stationäres Magnetfeld auf die zuvor durch das erste Magnetfeld beeinflussten Kerne ein, und es wird dann in der üblichen Weise mindestens ein MR-Experiment durchgeführt. Das zweite stationäre Magnetfeld kann wesentlich schwächer sein als das erste, benötigt aber eine für die Durchführung von MR-Untersuchungen ausreichende Homogenität.

Auch nach dem Abschalten des ersten stationären Magnetfeldes bleibt die dadurch bewirkte erhöhte Kernmagnetisierung eine Zeitlang bestehen, und das damit verbundene verbesserte Signal/Rauschverhältnis lässt sich ausnutzen, wenn unter der Einwirkung des zweiten stationären Magnetfeldes in dichtem zeitlichem Abstand zum ersten stationären Magnetfeld das bzw. die MR-Experimente durchgeführt werden.

Aufgabe der vorliegenden Erfindung ist es, ein Verfahren der eingangs genannten Art weiter zu verbessern. Diese Aufgabe wird erfindungsgemäß dadurch gelöst, dass die Richtungen des ersten und des zweiten stationären Magnetfeldes einen von 0° verschiedenen, vorzugsweise 90° betragenden Winkel miteinander einschließen und dass sich die beiden stationären Magnetfelder zeitlich überlappen.

Im Gegensatz zu dem eingangs genannten bekannten MR-Verfahren, bei dem die beiden stationären Felder die gleichen Richtungen haben, schließen bei der Erfindung die Richtungen dieser beiden Felder einen von 0 verschiedenen Winkel ein, vorzugsweise 90°. Es sei an dieser Stelle erwähnt, dass aus dem Aufsatz von Conolly et al in Proceedings SMRM, New York, 1993,Vol 3, p. 1365 bereits ein Verfahren bekannt ist, bei dem zunächst ein starkes Magnetfeld in x-Richtung ein- und ausgeschaltet wird und anschließend ein schwaches, in z-Richtung verlaufendes und oszillierendes Magnetfeld eingeschaltet wird, das den zuvor in x-Richtung verlaufenden Vektor der Kernmagnetisierung in der x,y-Ebene entsprechend der Larmor-Frequenz rotieren lässt

Die Erfindung basiert demgegenüber auf der Erkenntnis, dass dann, wenn die Kernmagnetisierung noch während der Wirksamkeit des ersten stationären Magnetfeldes unter den Einfluss des zweiten stationären Magnetfeldes gerät und danach das erste stationäre Magnetfeld verschwindet, der Kernmagnetisierungsvektor aus der durch das erste Magnetfeld vorgegebenen Richtung in die durch das zweite Magnetfeld vorgegebene Richtung gekippt wird.

Die Tatsache, dass auf diese Weise der Vektor der Kernmagnetisierung seine durch das erste stationäre Magnetfeld erhöhte Kernmagnetisierung (zunächst noch) beibehält, sich aber entsprechend dem zweiten stationären Magnetfeld ausrichtet, lässt sich in verschiedener Weise zur Verbesserung von MR-Untersuchungen ausnutzen. Eine erste, bevorzugte Möglichkeit ist in Anspruch 2 angegeben. Dabei wird die Kernmagnetisierung nicht durch ein besonders starkes erstes stationäres Magnetfeld erhöht, sondern dadurch, dass in Verbindung mit einem (relativ schwachen) Magnetfeld die Elektronenspinresonanz (ESR) eines im Untersuchungsobjekt befindlichen, ungepaarte Elektronen enthaltenden Kontrastmittels durch ein ESR-Hochfrequenzmagnetfeld angeregt wird. Die Anregung der Elektronenspinresonanz überträgt sich dabei auf die Kerne und erhöht so die Kernmagnetisierung; dieser Effekt wird allgemein als Overhauser-Effekt bezeichnet. Die anschließende Anregung der Kernmagnetisierung durch ein MR-Hochfrequenzmagnetfeld in Verbindung mit einem zweiten (ebenfalls vergleichsweise schwachen) stationären Magnetfeld erzeugt dabei MR-Signale mit einem Signal/Rauschverhältnis, wie es sonst nur in wesentlich stärkeren Magnetfeldern erreichbar ist.

Die dabei vorgesehene Ausgestaltung nach Anspruch 3 bringt den Vorteil, dass das ESR-Hochfrequenzmagnetfeld noch ausreichend tief in den Untersuchungsbereich eindringen kann und dass sich wegen des stärkeren zweiten stationären Magnetfeldes ein besseres Signal/Rauschverhältnis ergibt.

Eine Anordnung zur Durchführung des Verfahrens nach Anspruch 2 ist in Anspruch 6 beschrieben, die auf folgenden Überlegungen beruht: Die Frequenz des ESR-Hochfrequenzmagnetfeldes ist um einen Faktor von rund 660 größer als die Frequenz des MR-Hochfrequenzmagnetfeldes. Die ESR- und die MR-Hochfrequenzmagnetfelder müssen daher mit gesonderten Hochfrequenzspulen erzeugt werden. Wenn die Hochfrequenzfelder in der gleichen Richtung verlaufen würden (was notwendig wäre, wenn die beiden stationären Magnetfelder in derselben Richtung verlaufen), dann könnte sich eine starke Wechselwirkung zwischen den Spulen ergeben. Da jedoch die beiden stationären Magnetfelder zueinander senkrecht verlaufen, können auch die beiden Hochfrequenzfelder die mit jeweils einem dieser Felder zeitlich verknüpft sind, zueinander senkrecht verlaufen, wobei eine Wechselwirkung zwischen den sie erzeugenden Hochfrequenzspulen vermieden wird.

Aus diesem Grunde ist es auch möglich, gemäß Anspruch 7 zwei zueinander koaxiale Hochfrequenzspulen (unterschiedlichen Typs) zu verwenden, die den Untersuchungsbereich umschließen. Eine solche Ausgestaltung würde bei parallel zueinander verlaufendem ESR- und MR-Hochfrequenzmagnetfeld entweder zu starken Wechselwirkungen zwischen den Spulen oder - wenn der Durchmesser der MR-Spule wesentlich größer wäre als der der ESR-Spule - zu einem drastisch reduzierten Signal/Rauschverhältnis führen. Wenn bei der erfindungsgemäßen Anordnung die MR-Hochfrequenzspule und die ESR-Hochfrequenzspule einander und den Untersuchungsbereich sehr eng umschließen, ergibt sich ein gutes Signal/Rauschverhältnis, weil die Spulen sich - trotz ihrer räumlichen Nähe - gegenseitig nicht beeinflussen.

Eine Ausgestaltung von Anspruch 7 ist in Anspruch 8 angegeben. Eine Solenoid-Spule erzeugt ein in Richtung ihrer Achse verlaufendes Magnetfeld. Es gibt zwar auch andere Spulen, die ein Magnetfeld in dieser Richtung erzeugen, z.B. solche, die aus einer Mehrzahl von kreisförmigen nur induktiv miteinander gekoppelten Leiterschleifen bestehen; jedoch bietet eine Solenoid-Spule bei niedrigen Frequenzen Vorteile hinsichtlich des Signal/Rauschverhältnisses. - Vorteilhafte Ausgestaltungen der ESR-Hochfrequenzspulenanordnung sind in den Ansprüchen 9 bis 11 beschrieben. Alle diese Hochfrequenzspulenanordnungen erzeugen zur Spulenachse senkrechte Hochfrequenzmagnetfelder.

Bei der Ausgestaltung nach Anspruch 4 ergibt sich die erhöhte Kernmagnetisierung dadurch, dass das erste stationäre Magnetfeld wesentlich stärker ist als das zweite. Wenn das zweite stationäre Magnetfeld in Längsrichtung des Untersuchungsbereichs verläuft, kann das erste stationäre Magnetfeld mit einer verhältnismäßig einfachen Spule mit der benötigten Stärke erzeugt werden.

Eine weitere Ausgestaltung der Erfindung ist in Anspruch 5 beschrieben. Dabei wird die Tatsache ausgenutzt, dass mit dem Blut die darin durch das erste stationäre Magnetfeld erhöhte Kernmagnetisierung zum zweiten Abschnitt transportiert wird, wo das zweite stationäre Magnetfeld auf die durch das erste Magnetfeld beeinflussten Kerne einwirkt.

Die Erfindung wird nachstehend anhand der Zeichnungen näher erläutert. Es zeigen:

Fig. 1 Ein schematisches Blockschaltbild eines MR-Gerätes zur Durchführung von MR-Untersuchungen mit Hilfe des Overhauser-Effekts,

Fig. 2 den zeitlichen Verlauf verschiedener Magnetfelder bzw. Signale bei diesem Verfahren,

Fig. 3 eine zweite Ausführungsform eines erfindungsgemäßen MR-Gerätes,

Fig. 4 eine dritte Ausführungsform eines MR-Gerätes und

Fig. 5 den zeitlichen Verlauf der stationären Magnetfelder bei diesen Geräten.

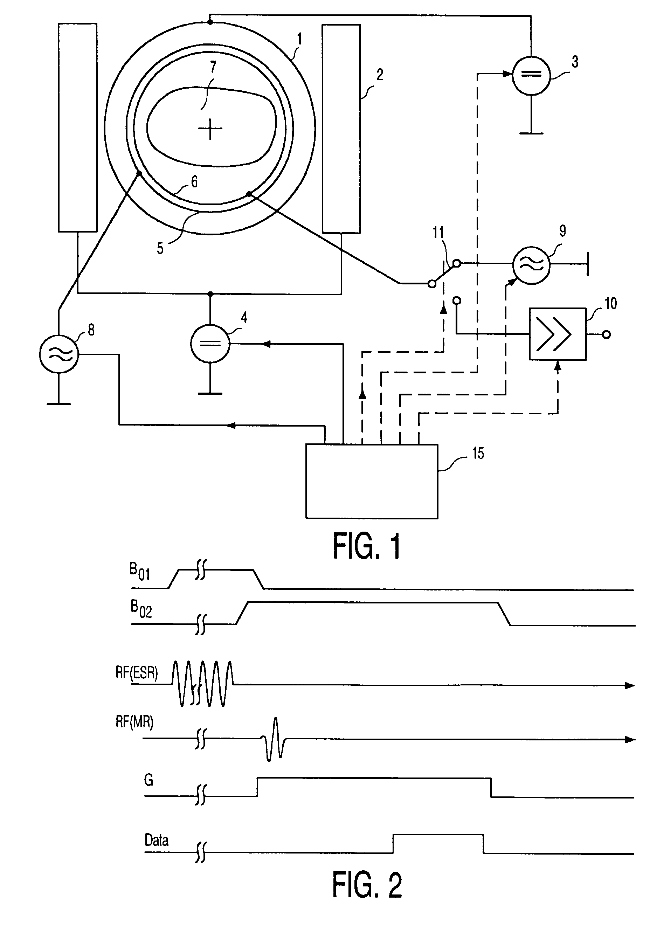

In Fig. 1 bezeichnet 1 einen ersten Magneten in Form einer Spule 1 zur Erzeugung eines ersten stationären Magnetfeldes $B_{01}$, das senkrecht zur Zeichenebene (d.h. in z-Richtung) verläuft. Das Magnetfeld kann eine Stärke von 5 mT aufweisen und muss keine hohen Anforderungen bezüglich seiner Homogenität und zeitlichen Stabilität erfüllen. Ein zweiter Magnet 2 liefert ein zweites stationäres Magnetfeld $B_{02}$, das in x-Richtung verläuft und somit senkrecht zum ersten stationären Magnetfeld $B_{01}$. Dieses Magnetfeld hat eine Stärke von 15 mT. Die Homogenität und die zeitliche Konstanz dieses Magnetfeldes müssen den hohen Anforderungen genügen, die sich für MR-Geräte allgemein ergeben. Die Ströme für die Magnete 1 und 2 werden von Stromquellen 3 und 4 geliefert, die durch eine Steuereinheit 15 ein- und ausschaltbar sind.

Eine ESR-Spule 5, die sich zylinderförmig senkrecht zur Zeichenebene erstreckt, erzeugt in einem Unrersuchungsbereich, in dem sich das zu untersuchende Objekt 7 befindet, ein ESR-Hochfrequenzmagnetfeld. Die ESR-Spule 5 muss ein zum ersten stationären Magnetfeld $B_{01}$ senkrechtes Hochfrequenzmagnetfeld erzeugen, um die Elektronenspinresonanz der in einem in das Objekt 7 injizierten Kontrastmittel enthaltenen freien (ungepaarten) Elektronen zu sättigen. Die ESR-Spule 5 ist vorzugsweise eine Quadraturspule vom sogenannten Birdcage-Typ. Dieser besitzt bekanntlich zur Richtung seiner Längsachse parallele Leiter auf einem Zylindermantel, deren Enden durch je eine Leiterschleife miteinander verbunden sind, und erzeugt ein in der x-y-Ebene rotierendes Hochfrequenzmagnetfeld. Statt dessen kann aber auch ein TEM-Resonator benutzt werden. Solche TEM-Resonatoren sind u.a. in einem Aufsatz von Röschmann in Proceedings SMR/ESRMB, Nice, 1995, p.1000 beschrieben. - Ebenso kann die ESR-Spule 5 durch eine Anzahl von den Untersuchungsbereich auf seinem Umfang jeweils teilweise umschließenden Oberflächenspulen gebildet werden.

Die Frequenz $f_{ESR}$ des ESR-Hochfrequenz-magnetfeldes hat die Größe

$$f_{ESR} = \gamma_e\, B_{01},$$

wobei $\gamma_e$ die gyromagnetische Konstante für Elektronenspinresonanz ist (ca. 28 GHz/T). Bei einer Stärke des stationären Magnetfeldes $B_{01}$ von 5 mT ergibt sich somit eine Frequenz des ESR-Hochfrequenzfeldes von 140 MHz. Bei derart hohen Frequenzen ergibt sich das Problem, dass die Eindringtiefe in das Objekt 7 gering und zwar um so geringer, je höher die Frequenz des ESR-Hochfrequenzmagnetfeldes ist. Es ist daher vorteilhaft, dass die Feldstärke von $B_{01}$ (5mT) kleiner ist als die des zweiten stationären Magnetfeldes $B_{02}$ (15mT).

Die ESR-Hochfrequenzspule 5 umschließt eine zylinderförmigen MR-Hochfrequenzspule 6 koaxial, die sich ebenfalls senkrecht zur Zeichenebene erstreckt. Die MR-Spule erzeugt jedoch ein in z-Richtung, also senkrecht zur Richtung des zweiten stationären Magnetfel-. des $B_{02}$ verlaufendes Hochfrequenzmagnetfeld. Die MR-Spule ist vorzugsweise eine sogenannte Solenoid-Spule. Eine Solenoid-Spule umfasst einen der helixförmig die in z-Richtung verlaufende Längsachse der Spule umschließt. Die Frequenz $f_{MR}$ des von der MR-Hochfrequenzspule 6 erzeugten MR-Hochfrequenzmagnetfeldes beträgt

$$f_{MR} = \gamma_n B_{02},$$

wobei $\gamma_n$ das gyromagnetische Verhältnis für Protonen ist (42 MHz/T). Für $B_{02} = 15$ mT ergibt sich eine Frequenz $f_{MR}$ von 630 kHz.

Weil die Wirkungsrichtungen der Spulen 5 und 6 zueinander senkrecht stehen, beeinflussen sie sich praktisch nicht. Sie können daher den Untersuchungsbereich eng umschließen. Die Durchmesser der Spulen 5 und 6 können auch so gewählt dass die ESR-Spule 5 von der MR-Spule umschlossen wird, sodass die ESR -Spule etwas stärker wirksam und das Signal/Rauschverhältnis der MR-Spule geringfügig niedriger ist.

Die Ströme für die beiden Spulen 5 und 6 werden von den Hochfrequenzstromquellen 8 und 9 geliefert, die ebenfalls durch die Steuereinheit 15 steuerbar sind. Die nach der Anregung durch das MR-Hochfrequenzmagnetfeld auftretenden MR-Signale können ebenfalls von der MR-Hochfrequenzspule 6 empfangen und einem Verstärker 10 zugeführt werden, wonach sie - auf nicht näher dargestellte Weise - digitalisiert und zur Erzeugung eines MR-Bildes herangezogen werden. Der Hochfrequenzverstärker 10 und der Hochfrequenzstromerzeuger 9 sind über einen Umschalter 11 mit der Hochfrequenzspule 6 verbunden. Statt dieselbe Hochfrequenzspule zum Erzeugen eines Hochfrequenzfeldes und zum Empfangen von Hochfrequenzsignalen zu verwenden, können auch getrennte Spulen für diese Zwecke benutzt werden, wie an sich bekannt.

Fig. 2 stellt den zeitlichen Ablauf einer MR-Untersuchung mit dem MR-Gerät nach Fig. 1 dar. Die Untersuchung beginnt mit dem Ein- und Ausschalten des ersten stationären Feldes $B_{01}$.(erste Zeile). Wenn dieses Feld seinen stationären Wert erreicht hat, wird mit der ESR-Spule 5 ein ESR-Hochfrequenzmagnetfeld erzeugt (zweite Zeile), das die Spins der im Untersuchungsbereich vorhandenen freien Elektronen sättigt. Die auf diese Weise im Elektronenspinsystem aufgenommene Energie überträgt sich auf das Kernspinsystem der im Untersuchungsbereich befindlichen Kerne, so dass sich eine erhöhte Kernmagnetisierung ergibt, wobei der Kernmagnetisierungsvektor zunächst - entsprechend dem ersten stationären Magnetfeld $B_{01}$ - in z-Richtung weist.

Noch bevor die Steuereinheit 5 den Stromgenerator 3 für den Magneten 1 wieder abschaltet, wird die Stromquelle 4 für den Magneten 2 eingeschaltet (dritte Zeile von Fig. 2), so dass sich die beiden stationären Magnetfelder $B_{01}$ und $B_{02}$ zeitlich überlappen. Dann wird der Stromgenerator 3 für den Magneten 1 abgeschaltet, so dass nur noch das Feld $B_{02}$ verbleibt. Die Kernmagnetisierung behält zunächst noch ihren infolge der ESR-Sättigung erhöhten Wert bei, jedoch richtet sie sich stets entsprechend dem jeweils insgesamt wirksamen stationären Magnetfeld aus.

Nach dem Verschwinden des stationären Magnetfelde $B_{01}$ - und bevor die erhöhte Kernmagnetisierung wieder abgeklungen ist -, erfolgt ein MR-Experiment, wobei die Steuereinheit 5 zunächst die Hochfrequentstromquelle 9 so einschaltet und moduliert, dass sich der in der vierten Zeile von Fig. 2 dargestellte Hochfrequenzimpuls des MR-Hochfrequenzmagnetfeldes ergibt, der ein Kippen des Magnetisierungsvektors aus der Richtung des weiterwirkenden stationären Magnetfeldes $B_{02}$ bewirkt.

Während dieses MR-Experimentes können in an sich bekannter Weise in x,y- bzw. z-Richtung verlaufende magnetische Gradientenfelder G (d.h. in Richtung des stationären Magnetfeldes $B_{02}$ verlaufende Magnetfelder mir einem Gradienten in x,y,z-Richtung) - durch in Fig. 1 nicht näher dargestellte Gradientenspulen - erzeugt werden, wie in der fünften Zeile von Fig. 2 schematisch angedeutet, die das Kippen des Kernmagnetisierungsvektors als Folge des MR-Hochfrequenzimpulses auf eine Schicht beschränken bzw. die die Phase der MR-Signale ortsabhängig kodieren. Die MR-Signale werden noch während der Wirkung wenigstens eines dieser Gradientenfelder von der MR-Spule 6 empfangen, vom Verstärker 10 verstärkt, digitalisiert und anschließend zur Rekonstruktion der Kernmagnetisierungsverteilung im Untersuchungsbereich bzw. in einer bestimmten Schicht des Untersuchungsbereichs herangezogen. Nach einem Intervall, das ausreicht, um das Kernspinsystem in seinen Zustand vor Einschaltung des stationären Magnetfeldes $B_{01}$ zurückkehren zu las-

sen, kann der in Fig. 2 dargestellte Ablauf- mit einer anderen Ortskodierung wiederholt werden.

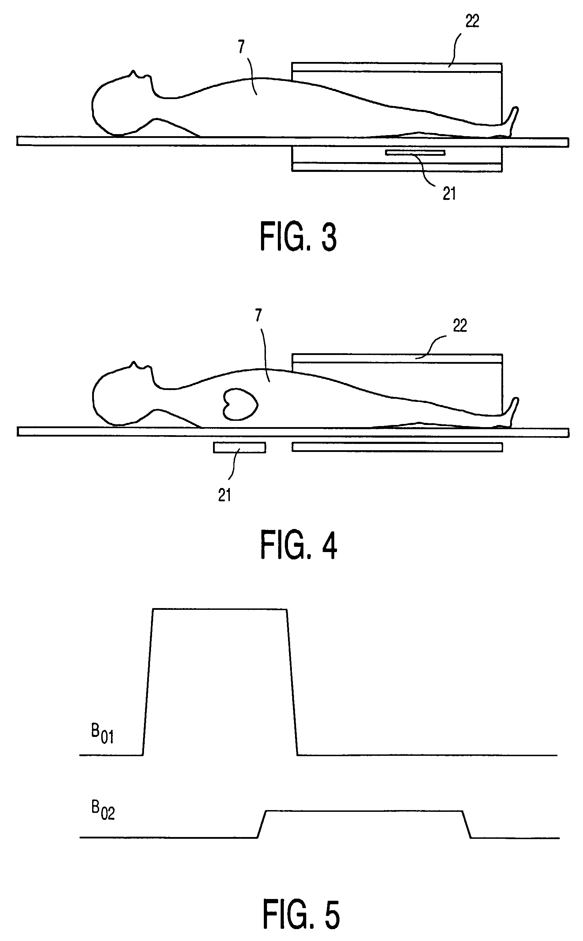

In Fig. 3 ist das Magnetsystem einer anderen Ausführungsform eines erfindungsgemäßen MR-Gerätes dargestellt. Ein erster Magnet wird durch eine Oberflächen-Spule 11 gebildet, die in ihrer unmittelbaren Umgebung ein starkes, aber auch sehr inhomogenes Magnetfeld senkrecht zur Längsrichtung des Patienten 7 erzeugt. Ein zweiter Magnet 12 erzeugt ein in Längsrichtung des Patienten 7 verlaufendes sehr homogenes stationäres Magnetfeld $B_{02}$, das allerdings wesentlich schwächer ist als das erste stationäre Magnetfeld $B_{01}$. Fig. 5 zeigt den zeitlichen Verlauf der beiden Magnetfelder. Die durch das erste stationäre Magnetfeld erhöhte Kernmagnerisierung bleibt nach dem Abschalten dieses Magnetfeldes zunächst noch erhalten und wird durch das zuvor schon eingeschaltete zweite stationäre Magnetfeld in dessen Richtung gekippt. Wie zuvor erläutert, kann in dieser Phase ein MR-Experiment erfolgen, wobei die Verbesserung des Signal/Rauschverhältnis durch die (noch) erhöhte Kernmagnetisierung ausgenutzt wird.

Fig. 4 zeigt eine andere Ausführungsform bei der die beiden Magnetsysteme 21 und 22 räumlich gegeneinander versetzt sind. Das Magnetsystem 21 erzeugt im Bereich des Herzen des Patienten 7 ein starkes, inhomogenes Magnetfeld $B_{01}$ (in x- oder in y-Richtung), wodurch die Kernmagnetisierung in dem durch die Herzkammern fließenden Blut erhöht wird. Dieses Blut - und die darin erhöhte Kernmagnetisierung - fließen in Richtung auf die Beine des Patienten, wo sich das zweite Magnetsystem befindet, das diese Kernmagnetisierung in z-Richtung ausrichtet. Dabei ist es wichtig, dass der Raum zwischen den beiden Magneten 21 und 22 nicht feldfrei bleibt, sondern dass die Kernspins immer mindestens einem der beiden Magnetfelder ausgesetzt sind, so dass sich die Kernmagnetisierung allmählich aus der Richtung des Magnetfeldes $B_{01}$ in die Richtung $B_{02}$ übergeht. Mit einem üblichen MR-Experiment, kann dann die Verteilung der Kernmagnetisierung im Bereich des zweiten Magnetsystems ermittelt werden. Das Signal/Rauschverhältnis der dabei empfangenen MR-Signale wird im wesentlichen durch das stationäre Magnetfeld $B_{01}$ bestimmt.

Das aus den empfangenen MR-Signalen abgeleitete MR-Bild stellt das Gefäßsystem des Patienten dar. Die Bildkontraste in diesem Bild können verstärkt werden, wenn von diesem MR-Bild das MR-Bild subtrahiert wird, das sich ergibt, wenn die gleiche Sequenz - aber ohne die Einschaltung des stationären Magnetfeldes $B_{01}$ - durchgeführt wird.

**Patentansprüche**

1. MR-Verfahren mir den Schritten

    - Erzeugung einer erhöhten Kernmagnetisierung in einem Untersuchungsbereich unter dem Einfluss eines ersten stationären Magnetfeldes,

    - Einwirken eines zweiten stationären Magnetfeldes auf die zuvor durch das erste Magnetfeld beeinflussten Kerne und

    - Durchführung mindestens eines MR-Experimentes, nachdem das erste stationäre Magnetfeld nicht mehr auf die Kerne einwirkt, jedoch bevor die durch dieses Magnetfeld beeinflusste Kernmagnetisierung abgeklungen ist, wobei das MR-Experiment die Anregung der Kernmagnetisierung durch ein MR-Hochfrequenzmagnetfeld unter dem Einfluss des zweiten stationären Magnetfeldes umfasst,

    dadurch gekennzeichnet,
    dass die Richtungen des ersten und des zweite stationären Magnetfeldes einen von 0° verschiedenen, vorzugsweise 90° betragenden Winkel miteinander einschließen und dass sich die beiden stationären Magnetfelder zeitlich überlappen.

2. MR-Verfahren nach Anspruch 1.
    dadurch gekennzeichnet,
    dass die Erzeugung der erhöhten Kernmagnetisierung die Anregung der Elektronenspinresonanz eines im Untersuchungsobjekt befindlichen, ungepaarte Elektronen enthaltenden Kontrastmittels unter dem Einfluss des ersten stationären Magnetfeldes durch ein ESR-Hochfrequenzmagnetfeld umfasst und dass die Richtungen des ESR-Hochfrequenzmagnetfeldes und des MR-Hochfrequenz-Magnetfeldes einen Winkel von zumindest annähernd 90° miteinander einschließen.

3. MR-Verfahren nach Anspruch 2, ,
    dadurch gekennzeichnet,
    dass das erste stationäre Magnetfeld schwächer ist als das zweite stationäre Magnetfeld.

4. MR-Verfahren nach Anspruch 1,
    dadurch gekennzeichnet,
    dass das erste stationäre Magnetfeld impulsartig ein- und ausgeschaltet wird und stärker ist als das zweite stationäre Magnetfeld, und dass das zweite stationäre Magnetfeld eine höhere Homogenität aufweist als das erste.

5. MR-Verfahren nach Anspruch 1 zur Untersuchung eines Patienten,
    dadurch gekennzeichnet,
    dass das erste stationäre Magnetfeld auf einen ersten Abschnitt und das zweite stationäre Magnetfeld auf einen zweiten Abschnitt des Patienten einwirkt, wobei das Blut vom ersten zum zweiten Abschnitt fließt.

6. Anordnung zur Durchführung des Verfahrens nach Anspruch 2, mit einem ersten Magneten zur Erzeugung eines ersten stationären Magnetfeldes, einer ESR-Hochfrequenzspulenanordung zur Erzeugung eines zum ersten stationären Magnetfeld zumindest annähernd senkrecht verlaufenden ESR-Hochfrequenzmagnetfeldes, und mit einer MR-Hochfrequenzspulenanordung zur Erzeugung und/oder zum Empfang eines MR-Hochfrequenzmagnetfeldes.

dadurch gekennzeichnet,

dass ein zweiter Magnet zur Erzeugung eines zweiten stationären Magnetfeldes vorgesehen ist, dessen Richtung mit der Richtung des ersten stationären Magnetfeldes einen von 0° verschiedenen, vorzugsweise 90° betragenden, Winkel bildet und dass die Richtung des MR-Hochfrequenzmagnetfeldes zumindest annähernd senkrecht zur Richtung des zweiten stationären Magnetfeldes und zur Richtung des ESR-Hochfrequenzmagnetfeldes verläuft.

7. Anordnung nach Anspruch 6,
dadurch gekennzeichnet,
dass die MR-Hochfrequenzspulenanordung (5) und die ESR-Hochfrequenzspulenanordung (6) einander umschließen und zueinander koaxial verlaufen.

8. Anordnung nach Anspruch 7,
dadurch gekennzeichnet,
dass die MR-Hochfrequenzspulenanordung eine Solenoid-Spule umfasst.

9. Anordnung nach Anspruch 7,
dadurch gekennzeichnet,
dass die ESR-Hochfrequenzspulenanordung eine Quadraturspule vom Birdcage-Typ ist.

10. Anordnung nach Anspruch 7,
dadurch gekennzeichnet,
dass die ESR-Hochfrequenzspulenanordung ein TEM-Resonator ist.

11. Anordnung nach Anspruch 7,
dadurch gekennzeichnet,
dass die ESR-Hochfrequenzspulenanordung ein Array von einen zylinderförmigen Raum umschließenden Oberflächenspulen umfasst.

FIG. 1

FIG. 2

FIG. 3

FIG. 4

FIG. 5